**Europäisches Patentamt**

**European Patent Office**

**Office européen des brevets**

(19)

(11) Veröffentlichungsnummer: **0 394 799**

**A1**

(12) **EUROPÄISCHE PATENTANMELDUNG**

(21) Anmeldenummer: **90107191.0**

(22) Anmeldetag: **14.04.90**

(51) Int. Cl.[5]: **C04B 35/00, C04B 35/64, H01L 39/12**

(30) Priorität: **24.04.89 DE 3913397**

(43) Veröffentlichungstag der Anmeldung:
**31.10.90 Patentblatt 90/44**

(84) Benannte Vertragsstaaten:
**CH DE FR GB IT LI SE**

(71) Anmelder: **ASEA BROWN BOVERI AG**
**Haselstrasse**
**CH-5401 Baden(CH)**

(72) Erfinder: **Baumann, Thomas, Dr.**
**Schulstrasse 6**
**CH-5430 Wettingen(CH)**
Erfinder: **Unternährer, Peter**
**Juchstrasse 8**
**CH-8116 Würenlos(CH)**

(54) **Verfahren zur Herstellung eines Hochtemperatur-Supraleiters.**

(57) Konventionell hergestellte Sinterkeramiken von Hochtemperatur-Supraleitern mit Sprungtemperaturen bis 125 K auf der Basis von $A_{n1}B_{n2-\epsilon 1}Ca_{n3+\epsilon 1}Cu_{n4}O_{n5+\epsilon 2}$, mit A = Tl oder Bi oder Pb oder eine Mischung dieser 3 Metalle, B = Be oder Mg oder Sr oder Ba oder Ra oder ein Gemisch dieser Elemente, n1 = 1 oder 2, n2 = 1 oder 2 oder 3, n3 = 2, n4 = 2 oder 3 oder 4, n5 = 8 oder 9 oder 10 oder 11, $|\epsilon 1| \leq 1$, $|\epsilon 2| < 1$, weisen eine kritische Stromdichte bis ca. 250 A/cm$^2$ auf, die für Anwendungen des Supraleiters z.B. für Hochleistungs-Magnetspulen zu niedrig ist. Um eine kritische Stromdichte von > 1750 A/cm$^2$ bei derartigen Supraleitern zu erreichen, erfolgt die Supraleitersynthese in einem Hauptprozess bei einer Temperatur im Bereich von 650 °C -900 °C während einer Dauer im Bereich von 1 h - 100 h. Vorausgehend kann zur Entgasung eine Vorsynthese-Wärmebehandlung bei einer Temperatur im Bereich von 650 °C - 900 °C während einer Dauer im Bereich von 0,5 h - 10 h und zur Materialverdichtung eine Korn-Aufschmelzung bei > 900 °C während 1 min - 1 h erfolgen. Zur Einstellung der gewünschten Sauerstoff-Stöchiometrie kann nach dem Hauptprozess eine Nachbehandlung bei 300 °C - 750 °C während 0,5 h - 5 h in Sauerstoffatmosphäre von $\leq$ 0,1 bar Partialdruck vorgesehen sein.

EP 0 394 799 A1

## Verfahren zur Herstellung eines Hochtemperatur-Supraleiters

Technisches Gebiet

Bei der Erfindung wird ausgegangen von einem . Verfahren zur Herstellung eines Hochtemperatur-Supraleiters nach dem Oberbegriff der Patentansprüche 1 und 3.

Stand der Technik

Mit dem Oberbegriff der Patentansprüche 1 und 3 nimmt die Erfindung auf einen Stand der Technik Bezug, wie er aus Physica C 156 (1988) S. 822 - 826, North-Holland, Amsterdam, bekannt ist. Dort wird die Herstellung von Supraleitern der Zusammensetzung $Bi_2Sr_2Ca_3Cu_4O_x$ und $Bi_2Sr_2Ca_4Cu_5Ox$ mit einer Sprungtemperatur von 110 K beschrieben. Dazu wurde ein Pulvergemisch aus $Bi_2O_3$, $SrCO_3$, $CaCO_3$ und CuO 12 h bei 800 $^\circ$C kalziniert. Dichte zerkleinerte Mineralbrocken von derart vorbehandeltem Material wurden in einem Platintiegel geschmolzen und mit einer auf 200 $^\circ$C aufgeheizten Kupferfläche abgeschreckt. Daraus wurden sehr dichte Glasplatten von ca. 0,5 mm Dicke gebildet und 7 d bei 850 $^\circ$C und 870 $^\circ$C in Luft geglüht.

In der Zeitschrift: Appl. Phys. Lett. 53(5), 1988, S. 414 - 416 ist die Herstellung eines Supraleiters mit einer Sprungtemperatur von 125 K und einer kritischen Stromdichte von ca. 250 $A/cm^2$ aus $Tl_2Ca_2Ba_2Cu_3O_x$ angegeben. Wegen der starken Flüchtigkeit von $Tl_2O_3$ wird zunächst $CaBaCu_2O_x$ durch eine Reaktion von $CaCO_3$, $BaCO_3$ und CuO im Verhältnis 1 : 1 : 2 bei 1195 K während einer Dauer von etwa 72 h synthetisiert. $Tl_2O_3$ und $CaBaCu_2O_x$ werden dann in stöchiometrischem Verhältnis gemischt, gemahlen und zu Tabletten von 12 mm Durchmesser und 1 mm - 2 mm Höhe gepresst. Eine Tablette wurde in einem Aluminiumoxid-Schiffchen schnell in einen auf 1200 K aufgeheizten Ofen gebracht und dort während 5 min - 8 min in einem Sauerstoffstrom gehalten. Danach wurde sie auf Zimmertemperatur abgeschreckt und nach 5 min erneut bei fliessendem Sauerstoff in den Ofen gebracht, dessen Heizung abgeschaltet wurde, so dass die Tablette langsam auf Zimmertemperatur abkühlte. Eine höhere Ofentemperatur von 1210 K und eine längere Verweildauer der Tablette von 10 min -15 min bei 1200 K führten zu einer Verringerung der Sprungtemperatur auf 114 K bzw. < 105 K. Wenn die Tablette vor der Wärmebehandlung mit einer Palladium-Silberfolie umwickelt wurde, betrug die optimale Heizdauer 15 min.

Nachteilig dabei ist, dass die damit erreichbare kritische Stromdichte des Supraleiters relativ niedrig ist, so dass dieser praktisch kaum angewendet werden kann.

Zum einschlägigen Stand der Technik wird auf die Zeitschrift Science 240 (1988) S. 631 - 633 verwiesen. Dort wird die Herstellung eines einphasigen Supraleiters mit einer Sprungtemperatur von 125 K aus $Tl_2Ba_2Ca_2Cu_3O_{10}$ beschrieben, wobei ein stöchiometrisches Pulvergemisch aus $Tl_2O_3$, $CaO_2$, $BaO_2$ und CuO zu Tabletten mit einem Durchmesser von 1,3 cm und einer Höhe von 10 cm gepresst und während einer unterschiedlich langen Dauer bei einer Temperatur im Bereich von 850 $^\circ$C - 925 $^\circ$C gehalten wurde. Wurde das Gemisch > 2 h auf 890 $^\circ$C erhitzt oder während einer kürzeren Dauer auf > 900 $^\circ$C, so entstand als Hauptphase $Tl_2Ba_2Ca_2Cu_3O_8$ und zum kleineren Teil $Tl_2Ba_2Ca_2Cu_3O_{10}$. Das Erhitzen erfolgte in abgeschlossenen Goldrohren.

Zusammensetzungen von Hochtemperatur-Supraleitern des Typs $(AO)_mM_2Ca_{n-1}Cu_nO_{2n+2}$ sind dem MRS Bulletin Vol. XIV, Nr. 1 (1989) S. 45 - 48 zu entnehmen. Das A-Kation kann eines der Elemente Tl, Pb, Bi oder eine Mischung dieser Elemente sein. m kann 1 oder 2 sein, für Bi nur 2. Das M-Kation kann Ba oder Sr sein. m bezeichnet die Anzahl aufeinanderliegender $CuO_2$-Schichten. Ca kann durch Sr ersetzt sein.

Darstellung der Erfindung

Die Erfindung, wie sie in den Patentansprüchen 1 und 3 definiert ist, löst die Aufgabe, ein Verfahren zur Herstellung eines Hochtemperatur-Supraleiters der eingangs genannten Art anzugeben, welcher eine vergleichsweise höhere kritische Stromdichte aufweist, insbesondere höher als 300 $A/cm^2$.

Ein Vorteil der Erfindung besteht darin, dass diese Supraleiter eine kritische Stromdichte erreichen, die um mindestens eine Zehnerpotenz höher liegt als bei bekannten Supraleitern der eingangs genannten Art. Infolge der relativ niedrigen Prozesstemperatur oder Prozessdauer wird eine Reaktion zwischen dem Substanzgemisch des Supraleiters und dem Material des Schmelztiegels vermieden.

Gemäss einer vorteilhaften Ausgestaltung der Erfindung kann durch ein kurzzeitiges Aufschmelzen der Korngrenzen des Substanzgemisches vor dessen Synthese zum Supraleiter eine deutliche Erhöhung der kritischen Stromdichte erreicht werden.

Eine Vorsynthese-Wärmebehandlung hat den Vorteil, dass die Oxide im atomaren Bereich durchmischt werden und unerwünschte Gase ($CO_2$, $O_2$) entweichen.

Eine einfache Nachbehandlung des Supraleiters in Sauerstoffatmosphäre bringt mehr Sauerstoff in den Supraleiter und somit eine weitere Verbesserung von dessen Leitfähigkeit.

Wege zur Ausführung der Erfindung

Zur Herstellung z.B. eines Supraleiters mit der Zusammensetzung $Tl_2Ba_2Ca_2Cu_3O_{10}$ mit einer Sprungtemperatur von 124 K wird ein Pulvergemisch aus $Tl_2O_3$, $BaO_2$, CaO und CuO, entsprechend einem stöchiometrischen Verhältnis von Tl : Ba : Ca : Cu von 2 : 2 : 2 : 3 hergestellt. Die Tabletten werden mit einer Dampfsperre umgeben, dass heisst in Platinfolie gewickelt, welche einen Gasaustausch mit der Umgebung erlaubt, aber bei hohen Temperaturen einen reduzierten Thalliumverlust der Tablette gewährleistet. Diese Tabletten werden nacheinander folgenden 4 Temperaturbehandlungen unterworfen:

1. Vorsynthese-Wärmebehandlung bei einer Temperatur im Bereich von 660 °C - 900 °C, vorzugsweise im Bereich von 820 °C - 880 °C, während einer Dauer im Bereich von 0,5 h - 10 h, vorzugsweise im Bereich von 0,5 h - 2 h;

2. Aufschmelzung der Korngrenzen des Gemisches bei einer Temperatur von > 900 °C, insbesondere im Bereich von 980 °C -1350 °C, vorzugsweise im Bereich von 1000 °C - 1200 °C, während einer Dauer im Bereich von 1 min - 1 h, vorzugsweise im Bereich von 3 min - 20 min;

3. Hauptprozess zur Supraleiter-Synthese bei einer Temperatur im Bereich von 660 °C - 900 °C, vorzugsweise im Bereich von 680 °C - 860 °C, während einer Dauer von > 2 h, insbesondere im Bereich von 2 h - 100 h, vorzugsweise im Bereich von 12 h - 48 h in Sauerstoffatmosphäre von ≤ 1 bar;

4. Nachbehandlung zur stöchiometrischen Sauerstoffeinstellung des Supraleiters bei einer Temperatur im Bereich von 300 °C - 750 °C, vorzugsweise im Bereich von 450 °C -600 °C, während einer Dauer im Bereich von 0,5 h - 5 h, vorzugsweise im Bereich von 1 h - 2 h, in reiner Sauerstoffatmosphäre oder bei einem Sauerstoffpartialdruck von > 0,1 bar.

Durch den Hauptprozess mit relativ niedriger Synthesetemperatur, d.h. ohne die o.g. Temperaturbehandlungen 1, 2 und 4, wird die Bildung eines Supraleiters erreicht. Bei der Supraleitersynthese wachsen grössere Plättchen bzw. Kristallite, welche kleinere aufzehren. Derartige Supraleiter sind hinsichtlich ihres Kristallaufbaus zu etwa 50 % leer, d.h. mit grossen Zwischenräumen zwischen den Kristalliten versehen. Die Stromdichte innerhalb der supraleitenden Kristallite liegt in der Grössenordnung von 106 A/cm². Korngrenzen, d.h. Verbindungen zwischen den Kristalliten sind die Ursasche dafür, dass die Gesamt-Stromdichte der Keramik um Grössenordnungen reduziert ist ( ≤ 1000 A/cm² ohne Magnetfeld und etwa 10 A/cm² bei einer Feldstärke von $10^{-2}$T .

Die Stromtragfähigkeit des Supraleiters kann verbessert werden, wenn die Stromübergänge zwischen den Kristalliten verbessert, d.h. statt punktförmiger flächenhafte Übergänge geschaffen werden. Dies kann erreicht werden: a) durch Heisspressung, b) Extrusion, c) durch hohen isostatischen Druck, d) Kristallisationshilfsmittel, e) durch Aufschmelzen der Körner des Substanzgemisches, wobei sich Materialdichten des Supraleiters von 90 %, entsprechend 10 % Leerraum zwischen den Kristalliten, erreichen lassen. Besonders vorteilhaft, da relativ einfach durchzuführen, ist das Aufschmelzen gemäss Punkt 2 der o.g. Temperaturbehandlungen. Damit lassen sich kritische Stromdichten des Supraleiters von 2 kA/cm² erreichen.

Zur Herstellung eines derartigen Supraleiters werden mit Platinfolie umwickelte Tabletten auf einem Träger oder Schiffchen oder Tiegel aus Aluminiumoxid-Keramik oder Platinfolie oder einem anderen chemisch resistenten Material mit hohem Schmelzpunkt schnell in einen vorerwärmten Ofen gebracht. Die Tablettentemperatur wird mit 2 Thermoelementen überwacht, die an entgegengesetzten Enden der Tabletten angeordnet sind. Etwa 7 min nach dem Einbringen der Tabletten in den Ofen herrschte bei einem Ausführungsbeispiel Temperaturgleichgewicht, wobei die Temperaturanzeige der 2 Thermoelemente um weniger als 2 K von der Temperatur eines Temperatursteuerelementes differierte.

Bei einer Herstellung des Supraleiters ohne vorausgegangenen Aufschmelzprozess wurde die Temperatur beim Hauptprozess 2 h zwischen 780 °C und 850 °C oder 16 h bei 700 °C gehalten. Die damit hergestellten Supraleiter wiesen einen hohen Gehalt an supraleitendem Material auf und schwebten bei einer Temperatur von 77 K über einem Magneten.

Bei einer Temperatur von 830 °C und reduziertem Sauerstoffpartialdruck während des Hauptprozesses entstand überwiegend ein Supraleiter mit dem stöchiometrischen Verhältnis von Tl : Ba : Ca : Cu von 2 : 2 : 2 : 3, nachstehend kurz als 2223-Phase bezeichnet. In keinem Fall erfolgte eine chemische Reaktion zwischen dem Pulvergemisch und dem Aluminium-Träger bzw. der Platinfolie.

Nachstehend werden 4 Ausführungsbeispiele angegeben, bei denen nur der Hauptprozess, ohne die o.g. Temperaturbehandlungen 1, 2 und 4, zur Anwendung kamen.

Beispiel 1:

Tabletten aus Gemischen mit o.g. Oxiden werden 14 h einer Temperatur von 710 °C in einer Gasatmosphäre mit 7 % Sauerstoff ausgesetzt. Das Reaktionsprodukt weist hauptsächlich die 2212-Phase mit Verunreinigungen von $Ca_2CuO_3$ und unbekannten Phasen auf. Die Sprungtemperatur liegt bei 100 K. Die Kristallitgrössen liegen im Bereich von 0,5 μm - 3 μm. Bei 77 K sieht die magnetische Hysteresekurve ganz anders aus als bei YBCO- oder Thallium-Supraleitern, die bei etwa 900 °C synthetisiert wurden. Die Hysteresekurve entspricht mehr einem klassischen Supraleiter, denn einem granularen, was auf das Vorhandensein von starken Bindungen zwischen den Kristalliten neben schwachen Bindungen im Supraleiter hindeutet.

Die Korngrenzen setzen dem Eindringen des magnetischen Feldes einen stärkeren Widerstand entgegen als sonst üblich, so dass die kritische Stromdichte in diesem Bereich weniger stark abnimmt. Material, das vorwiegend die 2212-Phase aufweist, aber bei 880 °C synthetisiert wurde, zeigt dieses Verhalten nicht. Ein ähnliches Ergebnis erhält man mit einer Synthesetemperatur von 690 °C in 100 %iger Sauerstoffatmosphäre, während mit einem Sauerstoffpartialdruck von 2 % eine andere, unbekannte Phase entstand, die oberhalb 77 K keine Supraleitung aufwies.

Beispiel 2:

Tabletten mit gemischten Oxiden wurden 2 h bei 780 °C in Atmosphären mit 2 % bzw. 7 % bzw. 20 % bzw. 100 % Sauerstoff gehalten. In allen Fällen entstand supraleitendes Material mit 2212-und 2223-Phase im Verhältnis 2 : 1 mit einer Sprungtemperatur bei 100 K. Aus magnetischen Messungen kann gefolgert werden, dass weniger starke Bindung als bei einer Synthesetemperatur von 700 °C vorliegt.

Beispiel 3:

Tabletten, bestehend aus dem Gemisch der Einzeloxide, wurden 2 h bei 830 °C in Atmosphären mit 2 % bzw. 20 % Sauerstoff gehalten. Bei 2 % Sauerstoff ist die 2223-Phase im Supraleiter dominant, bei 20 % Sauerstoff stehen die 2212-Phase im Verhältnis zur 2223-Phase wie 2 : 1. Die Sprungtemperatur liegt bei ≦ 100 K.

Beispiel 4:

Tabletten mit gemischten Oxiden wurden 2 h bei 850 °C in einer Atmosphäre mit 7 % Sauerstoff gehalten, wobei überwiegend 2223-Material entstand. Bei reiner Stickstoffatmosphäre entstand kein supraleitendes Material. Die mittlere Grösse der Kristallite liegt bei 5 μm - 10 μm. Die magnetische Hysterese ähnelt derjenigen von gutem YBaCu-Material mit schwacher Bindung zwischen den Kristalliten in thalliumhaltigen Supraleitern. Nachfolgend werden 2 Ausführungsbeispiele mit allen 4 Temperaturbehandlungen angegeben.

Beispiel 5:

$Tl_2O_3$, $BaO_2$, CaO und CuO wurden in stöchiometrischem Verhältnis von Tl : Ba : Ca : Cu von 2 : 2 : 2 : 3 gemischt und in Luft 2 h auf 874 °C erhitzt (Vorsynthese). Das resultierende Material wurde gemahlen und zu Tabletten von 13 mm Durchmesser gepresst. Diese Tabletten wurden in ein Platinrohr mit 13 mm Innendurchmesser und 100 mm Länge gesteckt und gepresst verschlossen. Das Platinrohr wurde nun 5 min lang in einen auf 960 °C vorgeheizten Ofen gebracht (Aufschmelzung) und anschliessend auf Zimmertemperatur abgeschreckt. Der so entstandene Barren war ein dicker schwarzer Körper, der sich leicht aus dem Platinrohr entfernen liess. Er enthielt unterschiedliche Kristallphasen mit einem sehr schwachen Supraleiteranteil.

Abgeschnittene Tabletten von 1 mm Dicke bzw. Höhe wurden in Platinfolie gewickelt und 60 h lang bei 870 °C gehalten (Hauptprozess), um den Supraleiter zu erhalten. Danach schloss sich für 1 h eine Nachbehandlung von unverpacktem Material bei 480 °C bei strömendem Sauerstoff an, um den Sauerstoffgehalt des Supraleiters stöchiometrisch einzustellen. Der so entstandene Supraleiter wies eine Dichte von 90 .% auf und schwebte bei der Temperatur des flüssigen Stickstoffs über einem Magneten.

Obgleich die Stöchiometrie des Ausgangsmaterials der Verbindung $Tl_2Ba_2Ca_2Cu_3O_{10}$ entsprach, wurde überwiegend die Verbindung $Tl_2Ba_2CaCu_2O_8$ im Supraleiter vorgefunden, welche sich offensichtlich in geschmolzenen Körpern häufiger findet. Die Sprungtemperatur betrug 110 K und die kritische Stromdichte 1, 6 kA/cm², d.h., etwa um 1 Zehnerpotenz höher als bei üblichen thalliumhaltigen Supraleitern. Aus der Wechselstrom-Magnetisierung ergibt sich gar eine kritische Stromdichte von ca. 7 kA/cm², wobei die Hystereseschleife derjenigen eines Supraleiters mit starker Bindung zwischen den Kristalliten entsprach.

Beispiel 6:

Die in Verbindung mit Beispiel 5 genannten Oxidpulver wurden entsprechend der Stöchiometrie von $Tl_2Ba_2CaCu_2O_8$ gemischt. Zum Aufschmelzen wurde anstelle des o.g. Platinrohres ein Aluminiumoxidrohr verwendet. Die Aufschmelztemperatur betrug 1300 °C. Ansonsten wurde wie im Beispiel 5 verfahren.

Eine Probe mit einem Querschnitt von 1,5 mm² transportierte verlustfrei einen Strom von 26 A und wurde danach normalleitend infolge einer starken Wärmeentwicklung an den Kontakten. Die kritische Stromdichte wurde in diesem Versuch nicht erreicht, sie war > 1,8 kA/cm².

Die Familie der thalliumhaltigen Supraleiter wurde hier als Arbeitsbeispiel gewählt, da sie Supraleiter mit Sprungtemperaturen weit oberhalb von 77 K liefert. Je nach Wärmebehandlung weisen sie gute oder schlechte Korngrenzeigenschaften auf; d.h. gute Korngrenzen (und somit hohe kritische Stromdichten) sind nicht das Resultat der Auswahl einer gewissen chemischen Substanzgruppe, sondern ein Resultat der richtigen Verfahrenstechnik. Generell eignet sich das erfindungsgemässe Verfahren für die Herstellung von Supraleitern aus $A_{n1}B_{n2-\epsilon 1}Ca_{n3+\epsilon 1}Cu_{n4}O_{n5+\epsilon 2}$ ist, mit A = Tl oder Bi oder Pb oder eine Mischung dieser 3 Metalle, B = Be oder Mg oder Sr oder Ba oder Ra oder ein Gemisch dieser Elemente, n1 = 1 oder 2, n2 = 1 oder 2 oder 3, n3 = 2, n4 = 2 oder 3 oder 4, n5 = 8 oder 9 oder 10 oder 11, $|\epsilon 1| \leq 1$, $|\epsilon 2| < 1$.

**Ansprüche**

1. Verfahren zur Herstellung eines Hochtemperatur-Supraleiters
   a) aus einem Substanzgemisch, das Sauerstoffverbindungen der Erdalkalielemente Kalzium und Barium sowie von Kupfer und wenigstens einer weiteren metallischen Komponente enthält, wobei Barium ganz oder teilweise durch Strontium ersetzt sein kann,
   b) wobei das Substanzgemisch in einem Hauptprozess einer 1. Prozesstemperatur im Bereich von 660 °C -790 °C ausgesetzt wird, dadurch gekennzeichnet,
   c) dass das Substanzgemisch vor dem Hauptprozess einem Aufschmelzprozess während einer 2. Prozessdauer im Bereich von 1 min - 1 h
   d) einer 2. Prozesstemperatur oberhalb von 900 °C ausgesetzt wird.

2. Verfahren nach Anspruch 1, dadurch gekennzeichnet, dass die 2. Prozessdauer im Bereich von 3 min - 20 min liegt.

3. Verfahren zur Herstellung eines Hochtemperatur-Supraleiters
   a) aus einem Substanzgemisch, das Sauerstoffverbindungen der Elemente Kalzium und Kupfer sowie wenigstens eine dritte metallische Komponente enthält,
   b) wobei das Substanzgemisch einem Aufschmelzprozess bei einer 2. Prozesstemperatur oberhalb von 900 °C und danach
   c) in einem Hauptprozess zu Supraleitersynthese einer 1. Prozesstemperatur oberhalb von 660 °C ausgesetzt wird, dadurch gekennzeichnet,
   d) dass die 1. Prozesstemperatur im Bereich von 600 °C - 900 °C liegt,
   e) dass die 2. Prozesstemperatur im Bereich von 980 °C - 1350 °C liegt und
   f) während einer 2. Prozessdauer im Bereich von 3 min - 20 min angewandt wird.

4. Verfahren nach Anspruch 2 oder 3, dadurch gekennzeichnet, dass die 2. Prozesstemperatur im Bereich von 1000 °C - 1200 °C liegt.

5. Verfahren nach einem der Ansprüche 1 bis 4, dadurch gekennzeichnet,
   a) dass das Substanzgemisch vor dem Hauptprozess einer Vorsynthese-Wärmebehandlung bei einer 3. Prozesstemperatur im Bereich von 820 °C - 880 °C
   b) während einer 3. Prozessdauer im Bereich von 0,5 h - 10 h ausgesetzt wird.

6. Verfahren nach Anspruch 5, dadurch gekennzeichnet, dass die 3. Prozessdauer im Bereich von 0,5 h - 2 h liegt.

7. Verfahren nach einem der Ansprüche 3 bis 6, dadurch gekennzeichnet,
   a) dass die 1. Prozessdauer im Bereich von 12 h -100 h,
   b) insbesondere im Bereich von 12 h - 48 h, und
   c) dass die 1. Prozesstemperatur im Bereich von 680 °C - 860 °C liegt.

8. Verfahren nach einem der Ansprüche 1 bis 7, dadurch gekennzeichnet, dass das Substanzgemisch als weitere metallische Komponente Wismut und/oder Thallium enthält, wobei Wismut und Thallium teilweise durch Blei ersetzt sein können.

EP 90107191.0

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl⁵) |
|---|---|---|---|
| A | EP - A2 - 0 311 337<br>(FUJIKURA LTD.)<br>  * Seite 4, Zeile 50 - Seite 6, Zeile 32; Seite 11, Zeile 19 - Seite 12, Zeile 8 *<br>-- | 1,3 | C 04 B 35/00<br>C 04 B 35/64<br>H 01 L 39/12 |
| P,A | DE - A1 - 3 830 092<br>(HOECHST AG)<br>  * Gesamt *<br>---- | 1,3 | |

RECHERCHIERTE
SACHGEBIETE (Int. Cl⁵)

C 04 B
H 01 L
H 01 B

Der vorliegende Recherchenbericht wurde für alle Patentansprüche erstellt.

| Recherchenort<br>WIEN | Abschlußdatum der Recherche<br>26-07-1990 | Prüfer<br>BECK |
|---|---|---|